# EUROPEAN PATENT APPLICATION

(11) **EP 4 611 508 A1**
(43) Date of publication of application: **03.09.2025**
(21) Application number: 24196163.0
(22) Date of filing: 23.08.2024
(51) Int. Cl.: H10H 20/01, H10H 20/831, H10H 20/84, H10H 29/01, H10H 29/24, H10H 29/80, H10H 29/85, H10H 29/853

(54) **INTERPOSER INCLUDING LIGHT EMITTING DIODE, METHOD FOR MANUFACTURING INTERPOSER INCLUDING LIGHT EMITTING DIODE, AND METHOD FOR INSPECTING LIGHT EMITTING DIODE**

(30) Priority: 27.02.2024 KR 20240028305
(71) Applicant: LG Display Co., Ltd., Seoul 07336 (KR)
(72) Inventor: HONG, Kiyong, 10845 Paju-si, Gyeonggi-do, (KR); SHIN, Yuseop, 10845 Paju-si, Gyeonggi-do, (KR); KWAK, YongSeok, 10845 Paju-si, Gyeonggi-do, (KR)
(74) Representative: Viering, Jentschura & Partner mbB Patent- und Rechtsanwälte

(57) **Abstract**

An interposer (100, 400) may include a temporary substrate (Sub), a common pad (PAD) disposed on the temporary substrate (Sub) and light emitting diodes (ED1, ED2) disposed on the common pad (PAD). Each of the light emitting diodes (ED1, ED2) may include a first electrode (124, 424), a first semiconductor layer (121), an emission layer (122), a second semiconductor layer (123), a second electrode (125), and a passivation layer (127, 427). The second electrode (125), the second semiconductor layer (123), the emission layer (122), the first semiconductor layer (121) and the first electrode (124, 424) may have a structure formed from sequential lamination. The passivation layer (127, 427) may enclose the second semiconductor layer (123), the emission layer (122) and the first semiconductor layer (121). The common pad (PAD) may be electrically connected to the second electrode (125) at a lower side of the light emitting diodes (ED1, ED2). The first electrode (124, 424) in each of the light emitting diodes (ED1, ED2) may extend to an upper portion of the passivation layer (127, 427). A method for inspecting light emitting diodes (ED1, ED2) disposed on a temporary substrate (Sub) is also disclosed.

## Description

### CROSS-REFERENCE TO RELATED APPLICATIONS

This application claims the benefit of and priority to Korean Patent Application No. 10-2024-0028305 filed on February 27, 2024.

### BACKGROUND

### 1. Technical Field

The present disclosure relates to apparatuses and methods, and particularly to, for example, without limitation, an interposer including a light emitting diode (LED), a method for manufacturing an interposer including a light emitting diode, and a method for inspecting a light emitting diode.

### 2. Description of the Related Art

Display devices may be used for, among others, a computer monitor, a television, a cellular phone, and the like, and a display device may employ, for example, an organic light emitting display (OLED) device which is a self-emitting device, a liquid crystal display (LCD) device which requires a separate light source, or the like.

An applicable range of the display device is diversified to personal digital assistants as well as monitors of computers and televisions, and a display device with a large display area and a reduced volume and weight is being studied.

Further, recently, a display device including a light emitting diode (LED) is attracting attention as a next generation display device. Since the light emitting diode is formed of an inorganic material, rather than an organic material, reliability is excellent so that a lifespan thereof is longer than that of the liquid crystal display device or the organic light emitting display device. Further, the light emitting diode has a fast lighting speed, excellent luminous efficiency, and a strong impact resistance so that a stability is excellent and an image having a high luminance can be displayed.

The description of the related art should not be assumed to be prior art merely because it is mentioned in or associated with this section. The description of the related art includes information that describes one or more aspects of the subject technology, and the description in this section does not limit the invention.

### SUMMARY

The inventors of the present disclosure have recognized the problems and needs of the related art, have performed extensive research and experiments, and have developed a new invention.

In one or more aspects, an object to be achieved by the present disclosure is to provide an interposer including a light emitting diode, a method for manufacturing an interposer including a light emitting diode and a method for inspecting the light emitting diode, by which luminous properties of a vertical light emitting diode can be inspected.

In one or more aspects, another object to be achieved by the present disclosure is to provide an interposer including a light emitting diode, a method for manufacturing an interposer including a light emitting diode and a method for inspecting the light emitting diode, by which the light emitting diode on the interposer can be inspected. Thus, the process cost can be reduced.

In one or more aspects, yet another object to be achieved by the present disclosure is to provide an interposer including a light emitting diode, a method for manufacturing an interposer including a light emitting diode and a method for inspecting the light emitting diode, by which the light emitting diode can be manufactured on the interposer. Thus, the process procedure can be simplified.

Objects of the present disclosure are not limited to the above-mentioned objects, and other objects, which are not mentioned above, can be clearly understood by those skilled in the art from the present disclosure. According to an aspect of the present disclosure, there is provided an interposer according to claim 1. According to another aspect of the present disclosure, there is provided a method for inspecting a plurality of light emitting diodes according to claim 8. Further embodiments are described in the dependent claims.

According to one or more aspects of the present disclosure, there is provided an interposer. The interposer may comprise a temporary substrate, a common pad disposed on the temporary substrate and a plurality of light emitting diodes (LEDs) disposed on the common pad, wherein each of the plurality of light emitting diodes includes a first electrode, a first semiconductor layer, an emission layer, a second semiconductor layer, a second electrode, and a passivation layer, wherein the second electrode, the second semiconductor layer, the emission layer, the first semiconductor layer and the first electrode have a structure formed from sequential lamination, wherein the passivation layer encloses the second semiconductor layer, the emission layer and the first semiconductor layer, wherein the common pad is connected to the second electrode for electrical connection at a lower side of the plurality of light emitting diodes, and wherein the first electrode in each of the plurality of light emitting diodes extends to an upper portion of the passivation layer.

According to one or more aspects of the present disclosure, there is provided a method for inspecting a plurality of light emitting diodes disposed on a temporary substrate, wherein each of the plurality of light emitting diodes may comprise a first electrode, a first semiconductor layer, an emission layer, a second semiconductor layer, and a second electrode. The method may comprise providing, on a wafer, a plurality of emission structures, wherein each of the plurality of emission structures includes the first semiconductor layer, the emission layer overlapping the first semiconductor layer, the second semiconductor layer overlapping the emission layer, and the second electrode overlapping the second semiconductor layer, providing a common pad connected to the second electrode on an upper surface of the wafer, attaching the temporary substrate to the common pad, removing the wafer, providing the first electrodes on first surfaces of the plurality of emission structures from which the wafer is removed, and inspecting luminous properties of the plurality of emission structures by electrically connecting probes to the common pad and the plurality of light emitting diodes, and wherein inspecting the luminous properties of the plurality of emission structures includes connecting at least one of the first electrodes to a first probe and connecting the common pad to a second probe.

According to one or more aspects of the present disclosure, there is provided an interposer. The interposer may comprise a substrate, a common pad on the substrate, and a plurality of light emitting diodes (LEDs) on the common pad, wherein each of the plurality of light emitting diodes includes a first electrode, an emission layer, a second electrode, and a passivation layer, the emission layer is disposed between the first electrode and the second electrode, the passivation layer encloses the emission layer, the common pad is connected to the second electrode for electrical connection through an opening at a lower portion of the passivation layer, the first electrode extends to an upper portion of the passivation layer, and the passivation layer of each of the plurality of light emitting diodes is separate and isolated from one or more other passivation layers of the plurality of light emitting diodes.

According to one or more aspects of the present disclosure, there is provided a method for manufacturing an interposer comprising a plurality of light emitting diodes, wherein each of the plurality of light emitting diodes may comprise a first electrode, an emission layer, a second electrode and a passivation layer. The method may comprise: providing, on a wafer, a plurality of emission structures, wherein each of the plurality of emission structures includes the second electrode and the emission layer overlapping the second electrode; providing, on the wafer, the passivation layer enclosing the emission layer; providing a common pad, wherein the common pad is connected to the second electrode of each of the plurality of emission structures through an opening in the passivation layer of each respective one of the plurality of emission structures; attaching a substrate to the common pad; removing the wafer; and providing the first electrodes on surfaces of the plurality of emission structures from which the wafer is removed.

Other details of example embodiments are included in the detailed description and the drawings.

According to one or more aspects of the present disclosure, an interposer and a light emitting diode can be manufactured simultaneously. Thus, the process cost can be reduced.

According to one or more aspects of the present disclosure, properties of each light emitting diode on the interposer can be inspected. Thus, the process yield can be improved.

According to one or more aspects of the present disclosure, only a light emitting diode determined as being normal is separated from the interposer. Thus, the convenience of process can be improved.

The effects according to one or more aspects of the present disclosure are not limited to the foregoing description, and other effects are included in the present disclosure or will be clearly understood by those skilled in the art from the present disclosure.

Other apparatuses, methods, features and advantages will be, or will become, apparent to one with skill in the art upon examination of the drawings and detailed description herein. It is intended that all such apparatuses, methods, features and advantages be included within this description, be within the scope of the present disclosure, and be protected by the following claims. Nothing in this section should be taken as a limitation on the claims. Further aspects and advantages are discussed below in conjunction with embodiments of the disclosure.

It is to be understood that both the foregoing description and the following description of the present disclosure are examples, and are intended to provide further explanation of the disclosure as claimed.

### BRIEF DESCRIPTION OF THE DRAWINGS

The accompanying drawings, which are included to provide a further understanding of the disclosure, are incorporated in and constitute a part of this disclosure, illustrate aspects and embodiments of the disclosure, and together with the description serve to explain principles and examples of the disclosure. In the drawings:
FIG. 1A is an enlarged plan view of an interposer according to an example embodiment of the present disclosure;
FIG. 1B is a cross-sectional view of the interposer according to an example embodiment of the present disclosure;
FIG. 2A and FIG. 2B are diagrams illustrating a method for inspecting a light emitting diode according to an example embodiment of the present disclosure;
FIG. 3A through FIG. 3J are diagrams illustrating a method for manufacturing an interposer and a light emitting diode according to an example embodiment of the present disclosure;
FIG. 4 is an enlarged plan view of an interposer according to another example embodiment of the present disclosure;
FIG. 5 is a cross-sectional view of an interposer according to another example embodiment of the present disclosure; and
FIG. 6A through FIG. 6J are diagrams illustrating a method for manufacturing an interposer and a light emitting diode according to another example embodiment of the present disclosure.

Throughout the drawings and the detailed description, unless otherwise described, the same drawing reference numerals should be understood to refer to the same elements, features, and structures. The sizes, lengths, and thicknesses of layers, regions and elements, and depiction thereof may be exaggerated for clarity, illustration, and/or convenience.

### DETAILED DESCRIPTION

Reference is now made in detail to embodiments of the present disclosure, examples of which may be illustrated in the accompanying drawings. In the following description, when a detailed description of well-known methods, functions, structures or configurations may unnecessarily obscure aspects of the present disclosure, the detailed description thereof may have been omitted for brevity. Further, repetitive descriptions may be omitted for brevity. The progression of processing steps and/or operations described is a non-limiting example.

The sequence of steps and/or operations is not limited to that set forth herein and may be changed to occur in an order that is different from an order described herein, with the exception of steps and/or operations necessarily occurring in a particular order. In one or more examples, two operations in succession may be performed substantially concurrently, or the two operations may be performed in a reverse order or in a different order depending on a function or operation involved.

Unless stated otherwise, like reference numerals may refer to like elements throughout even when they are shown in different drawings. Unless stated otherwise, the same reference numerals may be used to refer to the same or substantially the same elements throughout the specification and the drawings. In one or more aspects, identical elements (or elements with identical names) in different drawings may have the same or substantially the same functions and properties unless stated otherwise. Names of the respective elements used in the following explanations are selected only for convenience and may be thus different from those used in actual products.

Advantages and features of the present disclosure, and implementation methods thereof, are clarified through the embodiments described with reference to the accompanying drawings. The present disclosure may, however, be embodied in different forms and should not be construed as limited to the embodiments set forth herein. Rather, these embodiments are examples and are provided so that this disclosure may be thorough and complete to assist those skilled in the art to understand the inventive concepts without limiting the protected scope of the present disclosure.

Shapes, dimensions (e.g., sizes, lengths, widths, heights, thicknesses, locations, radii, diameters, and areas), proportions, ratios, angles, numbers, the number of elements, and the like disclosed herein, including those illustrated in the drawings, are merely examples, and thus, the present disclosure is not limited to the illustrated details. It is, however, noted that the relative dimensions of the components illustrated in the drawings are part of the present disclosure.

When the term "comprise," "have," "include," "contain," "constitute," "made of," "formed of," "composed of," or the like is used with respect to one or more elements (e.g., layers, films, regions, components, sections, members, parts, regions, areas, portions, steps, operations, and/or the like), one or more other elements may be added unless a term such as "only" or the like is used. The terms used in the present disclosure are merely used in order to describe particular example embodiments, and are not intended to limit the scope of the present disclosure. The terms of a singular form may include plural forms unless the context clearly indicates otherwise. The word "exemplary" is used to mean serving as an example or illustration. Embodiments are example embodiments. Aspects are example aspects. In one or more implementations, "embodiments," "examples," "aspects," and the like should not be construed to be preferred or advantageous over other implementations. An embodiment, an example, an example embodiment, an aspect, or the like may refer to one or more embodiments, one or more examples, one or more example embodiments, one or more aspects, or the like, unless stated otherwise. Further, the term "may" encompasses all the meanings of the term "can."

In one or more aspects, unless explicitly stated otherwise, an element, feature, or corresponding information (e.g., a level, range, dimension, size, or the like) is construed to include an error or tolerance range even where no explicit description of such an error or tolerance range is provided. An error or tolerance range may be caused by various factors (e.g., process factors, internal or external impact, noise, or the like). In interpreting a numerical value, the value is interpreted as including an error range unless explicitly stated otherwise.

When a positional relationship between two elements (e.g., layers, films, regions, components, sections, members, parts, regions, areas, portions, and/or the like) are described using any of the terms such as "on," "on a top of," "upon," "on top of," "over," "under," "above," "upper," "below," "lower," "beneath," "near," "close to," "adjacent to," "beside," "next to," "at or on a side of," and/or the like indicating a position or location, one or more other elements may be located between the two elements unless a more limiting term, such as "immediate(ly)," "direct(ly)," or "close(ly)," is used. For example, when an element and another element are described using any of the foregoing terms, this description should be construed as including a case in which the elements contact each other directly as well as a case in which one or more additional elements are disposed or interposed therebetween. Furthermore, the spatially relative terms such as the foregoing terms as well as other terms such as "front," "rear," "back," "left," "right," "top," "bottom," "downward," "upward," "up," "down," "column," "row," "vertical," "horizontal," "diagonal," and the like refer to an arbitrary frame of reference. For example, these terms may be used for an example understanding of a relative relationship between elements, including any correlation as shown in the drawings. However, embodiments of the disclosure are not limited thereby or thereto. The spatially relative terms are to be understood as terms including different orientations of the elements in use or in operation in addition to the orientation depicted in the drawings or described herein. For example, where a lower element or an element positioned under another element is overturned, then the element may be termed as an upper element or an element positioned above another element. Thus, for example, the term "under" or "beneath" may encompass, in meaning, the term "above" or "over." An example term "below" or the like, can include all directions, including directions of "below," "above" and diagonal directions. Likewise, an example term "above," "on" or the like can include all directions, including directions of "above," "on," "below" and diagonal directions.

In describing a temporal relationship, when the temporal order is described as, for example, "after," "subsequent," "next," "before," "preceding," "prior to," or the like, a case that is not consecutive or not sequential may be included and thus one or more other events may occur therebetween, unless a more limiting term, such as "just," "immediate(ly)," or "direct(ly)," is used.

It is understood that, although the terms "first," "second," and the like may be used herein to describe various elements (e.g., layers, films, regions, components, sections, members, parts, regions, areas, portions, steps, operations, and/or the like), these elements should not be limited by these terms, for example, to any particular order, precedence, or number of elements. These terms are used only to distinguish one element from another. For example, a first element may denote a second element, and, similarly, a second element may denote a first element, without departing from the scope of the present disclosure. Furthermore, the first element, the second element, and the like may be arbitrarily named according to the convenience of those skilled in the art without departing from the scope of the present disclosure. For clarity, the functions or structures of these elements (e.g., the first element, the second element, and the like) are not limited by ordinal numbers or the names in front of the elements. Further, a first element may include one or more first elements. Similarly, a second element or the like may include one or more second elements or the like.

In describing elements of the present disclosure, the terms "first," "second," "A," "B," "(a)," "(b)," or the like may be used. These terms are intended to identify the corresponding element(s) from the other element(s), and these are not used to define the essence, basis, order, or number of the elements.

For the expression that an element (e.g., layer, film, region, component, section, member, part, region, area, portion, or the like) is "connected," "coupled," "attached," "adhered," "linked," or the like to another element, the element can not only be directly connected, coupled, attached, adhered, linked, or the like to another element, but also be indirectly connected, coupled, attached, adhered, linked, or the like to another element with one or more intervening elements disposed or interposed between the elements, unless otherwise specified.

For the expression that an element (e.g., layer, film, region, component, section, member, part, region, area, portion, or the like) "contacts," "overlaps," or the like with another element, the element can not only directly contact, overlap, or the like with another element, but also indirectly contact, overlap, or the like with another element with one or more intervening elements disposed or interposed between the elements, unless otherwise specified.

The phase that an element (e.g., layer, film, region, component, section, member, part, region, area, portion, or the like) is "provided," "disposed," "connected," "coupled," or the like in, on, with or to another element may be understood, for example, as that at least a portion of the element is provided, disposed, connected, coupled, or the like in, on, with or to at least a portion of another element. The phrase "through" may be understood, for example, to be at least partially through or entirely through. The phase that an element (e.g., layer, film, region, component, section, member, part, region, area, portion, or the like) "contacts," "overlaps," or the like with another element may be understood, for example, as that at least a portion of the element contacts, overlaps, or the like with a least a portion of another element.

The terms such as a "line" or "direction" should not be interpreted only based on a geometrical relationship in which the respective lines or directions are parallel, perpendicular, diagonal, or slanted with respect to each other, and may be meant as lines or directions having wider directivities within the range within which the components of the present disclosure may operate functionally.

The term "at least one" should be understood as including any and all combinations of one or more of the associated listed items. For example, each of the phrases "at least one of a first item, a second item, or a third item" and "at least one of a first item, a second item, and a third item" may represent (i) a combination of items provided by two or more of the first item, the second item, and the third item or (ii) only one of the first item, the second item, or the third item. Further, at least one of a plurality of elements can represent (i) one element of the plurality of elements, (ii) some elements of the plurality of elements, or (iii) all elements of the plurality of elements.

The expression of a first element, a second elements "and/or" a third element should be understood as one of the first, second and third elements or as any or all combinations of the first, second and third elements. By way of example, A, B and/or C may refer to only A; only B; only C; any of A, B, and C (e.g., A, B, or C); some combination of A, B, and C (e.g., A and B; A and C; or B and C); or all of A, B, and C. Furthermore, an expression "A/B" may be understood as A and/or B. For example, an expression "A/B" may refer to only A; only B; A or B; or A and B.

In one or more aspects, the terms "between" and "among" may be used interchangeably simply for convenience unless stated otherwise. For example, an expression "between a plurality of elements" may be understood as among a plurality of elements. In another example, an expression "among a plurality of elements" may be understood as between a plurality of elements. In one or more examples, the number of elements may be two. In one or more examples, the number of elements may be more than two. Furthermore, when an element (e.g., layer, film, region, component, section, member, part, region, area, portion, or the like) is referred to as being "between" at least two elements, the element may be the only element between the at least two elements, or one or more intervening elements may also be present.

In one or more aspects, the phrases "each other" and "one another" may be used interchangeably simply for convenience unless stated otherwise. For example, an expression "different from each other" may be understood as being different from one another. In another example, an expression "different from one another" may be understood as being different from each other. In one or more examples, the number of elements involved in the foregoing expression may be two. In one or more examples, the number of elements involved in the foregoing expression may be more than two.

In one or more aspects, the phrases "one or more among" and "one or more of" may be used interchangeably simply for convenience unless stated otherwise.

The term "or" means "inclusive or" rather than "exclusive or." That is, unless otherwise stated or clear from the context, the expression that "x uses a or b" means any one of natural inclusive permutations. For example, "a or b" may mean "a," "b," or "a and b." For example, "a, b or c" may mean "a," "b," "c," "a and b," "b and c," "a and c," or "a, b and c."

Features of various embodiments of the present disclosure may be partially or entirely coupled to or combined with each other, may be technically associated with each other, and may be variously operated, linked or driven together in various ways. Embodiments of the present disclosure may be implemented or carried out independently of each other or may be implemented or carried out together in a co-dependent or related relationship. In one or more aspects, the components of each apparatus and device according to various embodiments of the present disclosure are operatively coupled and configured.

Unless otherwise defined, the terms (including technical and scientific terms) used herein have the same meaning as commonly understood by one of ordinary skill in the art to which example embodiments belong. It is further understood that terms, such as those defined in commonly used dictionaries, should be interpreted as having a meaning that is, for example, consistent with their meaning in the context of the relevant art and should not be interpreted in an idealized or overly formal sense unless expressly defined otherwise herein.

The terms used herein have been selected as being general in the related technical field; however, there may be other terms depending on the development and/or change of technology, convention, preference of technicians, and so on. Therefore, the terms used herein should not be understood as limiting technical ideas, but should be understood as examples of the terms for describing example embodiments.

Further, in a specific case, a term may be arbitrarily selected by an applicant, and in this case, the detailed meaning thereof is described herein. Therefore, the terms used herein should be understood based on not only the name of the terms, but also the meaning of the terms and the content hereof.

In the following description, various example embodiments of the present disclosure are described in detail with reference to the accompanying drawings. With respect to reference numerals to elements of each of the drawings, the same elements may be illustrated in other drawings, and like reference numerals may refer to like elements unless stated otherwise. The same or similar elements may be denoted by the same reference numerals even though they are depicted in different drawings. In addition, for convenience of description, a scale, dimension, size, and thickness of each of the elements illustrated in the accompanying drawings may be different from an actual scale, dimension, size, and thickness, and thus, embodiments of the present disclosure are not limited to a scale, dimension, size, and thickness illustrated in the drawings.

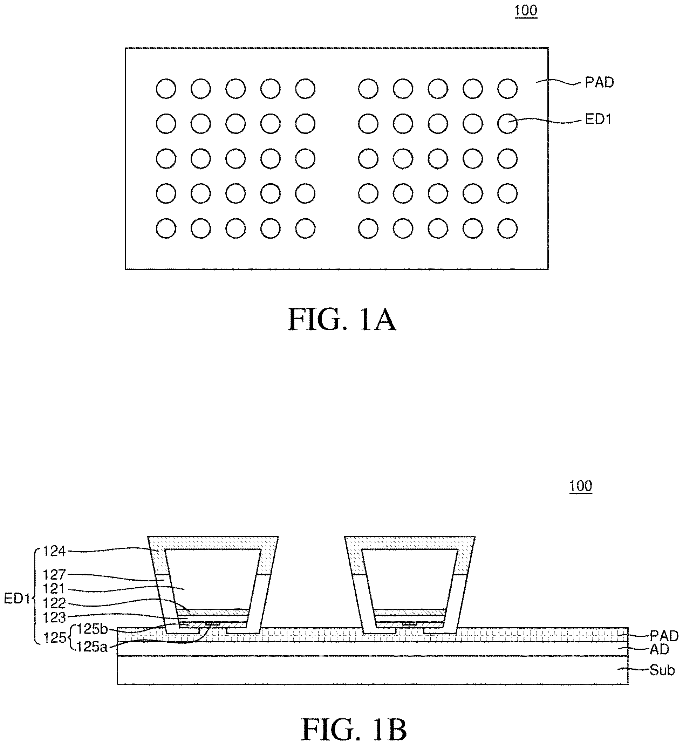

FIG. 1A is an enlarged plan view of an interposer according to an example embodiment of the present disclosure. FIG. 1B is a cross-sectional view of the interposer according to an example embodiment of the present disclosure.

Referring to FIG. 1A and FIG. 1B, a temporary substrate Sub is disposed at a lower portion of an interposer 100. The temporary substrate Sub may be made of an insulating material. For example, the temporary substrate Sub may be made of photo acryl (PAC), polyimide (PI), polynorbornene (PNB), and benzocyclobutene (BCB), but is not limited thereto. The temporary substrate Sub may also be made of glass.

Referring to FIG. 1B, an adhesive layer AD is disposed on the temporary substrate Sub. The adhesive layer AD is disposed between the temporary substrate Sub and a common pad PAD. Also, the adhesive layer AD may be provided on the entire surface of the temporary substrate Sub to bond the temporary substrate Sub to the common pad PAD. The adhesive layer AD may be an organic insulating layer. The adhesive layer AD may be made of a photocurable adhesive material which is cured by light. For example, the adhesive layer AD may be made of an acryl-based material including a photosensitizer, but is not limited thereto.

Referring to FIG. 1B, the common pad PAD is disposed on the adhesive layer AD. The common pad PAD may be made of a conductive material. For example, the common pad PAD may be made of copper (Cu), aluminum (Al), molybdenum (Mo), nickel (Ni), titanium (Ti), chrome (Cr) or an alloy thereof. Meanwhile, the common pad PAD may be made of a material suitable for a sacrificial layer process. For example, the common pad PAD may be made of aluminum (Al), but is not limited thereto. Referring to FIG. 1A and FIG. 1B, an upper surface of the common pad PAD may be exposed between a plurality of light emitting diodes ED1.

Referring to FIG. 1A and FIG. 1B, the plurality of light emitting diodes ED1 is disposed on the common pad PAD.

Each of the plurality of light emitting diodes ED1 includes a first semiconductor layer 121, an emission layer 122, a second semiconductor layer 123, a first electrode 124, a second electrode 125, and a passivation layer 127.

Hereinafter, the description will be made under the assumption that the light emitting diode ED1 on the common pad PAD has a vertical structure in which the second electrode 125, the second semiconductor layer 123, the emission layer 122, the first semiconductor layer 121, and the first electrode 124 are sequentially laminated. In one or more aspects, sequential lamination results in a particular structure; and thus, the second electrode 125, the second semiconductor layer 123, the emission layer 122, the first semiconductor layer 121, and the first electrode 124 may have a structure formed from sequential lamination. In one or more examples, a structure resulting from lamination may be different from a structure resulting from another process (e.g., vapor deposition). However, the type of the light emitting diode ED1 is not limited thereto.

Referring to FIG. 1B, the second semiconductor layer 123 of the light emitting diode ED1 is disposed on the common pad PAD, and the first semiconductor layer 121 is disposed on the second semiconductor layer 123. Each of the first semiconductor layer 121 and the second semiconductor layer 123 may be formed by doping a specific material with n-type or p-type impurities. For example, each of the first semiconductor layer 121 and the second semiconductor layer 123 may be formed by doping a material, such as gallium nitride (GaN), indium aluminum phosphide (InAlP), or gallium arsenide (GaAs), with n-type or p-type impurities. The p-type impurities may be magnesium (Mg), zinc (Zn), beryllium (Be), or the like, and the n-type impurities may be silicon (Si), germanium (Ge), tin (Sn), or the like. However, the present disclosure is not limited thereto.

Meanwhile, the second semiconductor layer 123 may have a smaller width than the first semiconductor layer 121. Also, the widths of the second semiconductor layer 123 and the first semiconductor layer 121 may gradually increase from the common pad PAD. However, the present disclosure is not limited thereto.

The emission layer 122 is disposed between the first semiconductor layer 121 and the second semiconductor layer 123. The emission layer 122 may emit light when supplied with holes and electrons from the first semiconductor layer 121 and the second semiconductor layer 123. The emission layer 122 may be configured by a single layer or a multi-quantum well (MQW) structure and made of, for example, indium gallium nitride (InGaN) or gallium nitride (GaN), but is not limited thereto.

The first electrode 124 of the light emitting diode ED1 is disposed on the first semiconductor layer 131. For example, the first semiconductor layer 121 may be a semiconductor layer doped with n-type impurities, and the first electrode 124 may be a cathode. Meanwhile, the first electrode 124 of the light emitting diode ED1 may be disposed on the passivation layer 127. For example, the first electrode 124 may extend from an upper portion of the first semiconductor layer 121 to an upper portion of the passivation layer 127.

In this case, when the passivation layer 127 exposes a part of a side surface of the first semiconductor layer 121, the first electrode 124 may extend from the upper portion of the first semiconductor layer 121 to cover the part of the side surface of the first semiconductor layer 121.

The first electrode 124 may be made of a conductive material, for example, a transparent conductive material such as indium tin oxide (ITO) or indium zinc oxide (IZO) or an opaque conductive material such as titanium (Ti), gold (Au), silver (Ag), copper (Cu) or an alloy thereof, but is not limited thereto.

The second electrode 125 of the light emitting diode ED1 is disposed under the second semiconductor layer 123. The second electrode 125 may be electrically connected to the second semiconductor layer 123. Also, the second electrode 125 in each of the plurality of light emitting diodes ED1 may be in contact with the common pad PAD.

For example, the second semiconductor layer 123 may be a semiconductor layer doped with p-type impurities, and the second electrode 125 may be an anode.

The second electrode 125 includes a 2-1 electrode 125a and a 2-2 electrode 125b.

The 2-1 electrode 125a may be disposed at a central portion of a lower surface of the second semiconductor layer 123.

The 2-1 electrode 125a may contain a ferromagnetic material. For example, the 2-1 electrode 125a may contain a ferromagnetic material such as iron (Fe), cobalt (Co), or nickel (Ni), but is not limited thereto.

The 2-2 electrode 125b is disposed under the 2-1 electrode 125a. The 2-2 electrode 125b may cover lower surface and side surface of the 2-1 electrode 125a and extend from a lower portion of the 2-1 electrode 125a to cover a lower surface of the second semiconductor layer 123.

The 2-2 electrode 125b may be made of a transparent conductive material such as indium tin oxide (ITO) or indium zinc oxide (IZO), but is not limited thereto.

If the light emitting diode ED 1 is a self-assembly light emitting diode, the 2-1 electrode 125a may be disposed to facilitate the assembly of the light emitting diode ED1. Thus, if the light emitting diode ED1 is not a self-assembly light emitting diode, the second electrode 125 may not include the 2-1 electrode 125a, but may include only the 2-2 electrode 125b, but is not limited thereto.

Then, the passivation layer 127 enclosing the first semiconductor layer 121, the emission layer 122, the second semiconductor layer 123, and the second electrode 125 is disposed. The passivation layer 127 may be made of an insulating material to protect the first semiconductor layer 121, the emission layer 122, and the second semiconductor layer 123. For example, the passivation layer 127 may be made of silicon nitride (SiNx) and aluminum oxide (Al₂O₃).

Meanwhile, the passivation layer 127 may enclose the entire side portion of the emission layer 122 and the second semiconductor layer 123 and only the part of the side surface of the first semiconductor layer 121. For example, the passivation layer 127 may enclose only a lower side surface of the first semiconductor layer 121. Alternatively, the passivation layer 127 may be disposed only under the first electrode 124 enclosing an upper side surface of the first semiconductor layer 121.

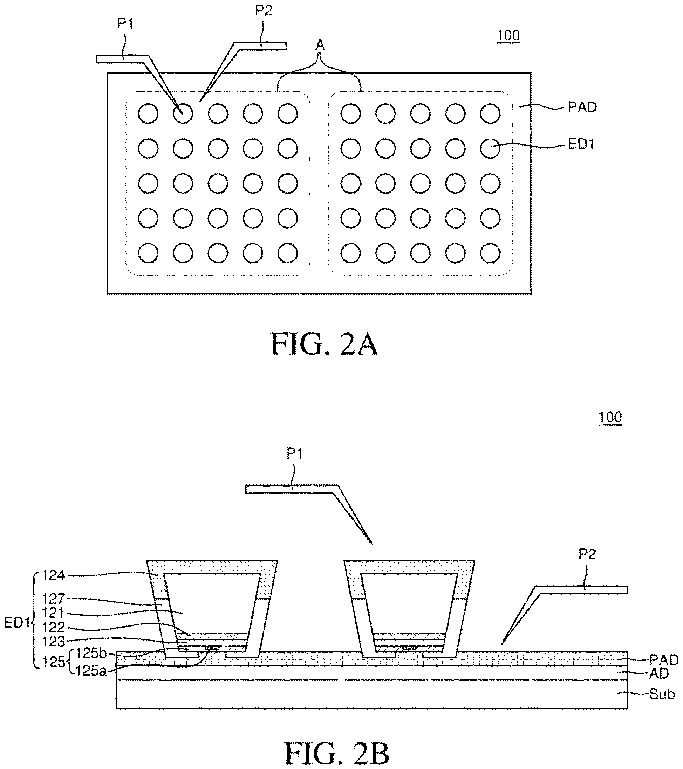

The passivation layer 127 may extend to a lower portion of the second semiconductor layer 123 to enclose a side portion of the second electrode 125. For example, the passivation layer 127 may enclose an edge of the 2-2 electrode 125b. In this case, the passivation layer 127 may include a contact hole for exposing the second electrode 125. Accordingly, referring to FIG. 2, the second electrode 125 in each of the plurality of light emitting diodes ED1 may be in contact with the common pad PAD through the contact hole of the passivation layer 127.

Hereinafter, a method for inspecting the light emitting diode ED1 according to an example embodiment of the present disclosure will be described with reference to FIG. 2A and FIG. 2B.

FIG. 2A and FIG. 2B are diagrams illustrating a method for inspecting a light emitting diode according to an example embodiment of the present disclosure. FIG. 2A is an enlarged plan view of the interposer illustrating the method for inspecting a light emitting diode according to an example embodiment of the present disclosure. FIG. 2B is a cross-sectional view of the interposer illustrating the method for inspecting a light emitting diode according to an example embodiment of the present disclosure.

Referring to FIGS. 2A and 2B, a first probe P1 is connected to the first electrode 124 in one of the plurality of light emitting diodes ED1 disposed on the temporary substrate Sub. Also, a second probe P2 is connected to one surface of the common pad PAD exposed on the temporary substrate Sub.

Meanwhile, when the second probe P2 becomes farther away from the first probe P1, a voltage drop occurs, which may result in an inaccurate inspection. Accordingly, inspection of the plurality of light emitting diodes ED1 may be performed for each unit area A. For example, the first probe P1 may move toward each of the plurality of light emitting diodes ED1 on the interposer 100, and may be brought into contact with the first electrode 124 of the interposer 100. The second probe P2 may move to each unit area A and perform inspection. For example, the second probe P2 may be fixed at one position in the entire area of the common pad PAD and may be in contact with the common pad PAD. For example, when the second probe P2 contacts the common pad PAD in a unit area A, the first probe P1 may move from one light emitting diode to a next light emitting diode until all light emitting diodes within the unit area A have been contacted in sequence. In another example, a probe may include multiple probes, and multiple light emitting diodes may be probed in parallel to make multiple measurements simultaneously.

Then, an electrical signal may be applied to the first probe P1 and the second probe P2 to inspect optical and electrical properties of the plurality of light emitting diodes ED1 (e.g., one light emitting diode at a time in sequence). For example, properties of the light emitting diode ED1, such as the defect levels, impurity levels, quality of film, and target wavelength, may be checked.

In addition, some of the plurality of light emitting diodes ED1, which do not emit light or do not satisfy criteria for emission of light are determined as being defective. The defective light emitting diodes ED1 are selectively removed from the temporary substrate Sub. For example, after the position of the light emitting diode ED1 determined as being defective on the interposer 100 is checked, the defective light emitting diode ED1 may be selectively removed from the interposer 100. Then, the light emitting diodes ED1 disposed on the interposer 100 may be directly transferred onto a display panel. If a great number of light emitting diodes ED1 on the interposer 100 are determined as being defective, normal light emitting diodes ED1 may be selectively separated from the interposer 100. Thereafter, the normal light emitting diodes ED1 separated from the interposer 100 may be transferred onto the display panel.

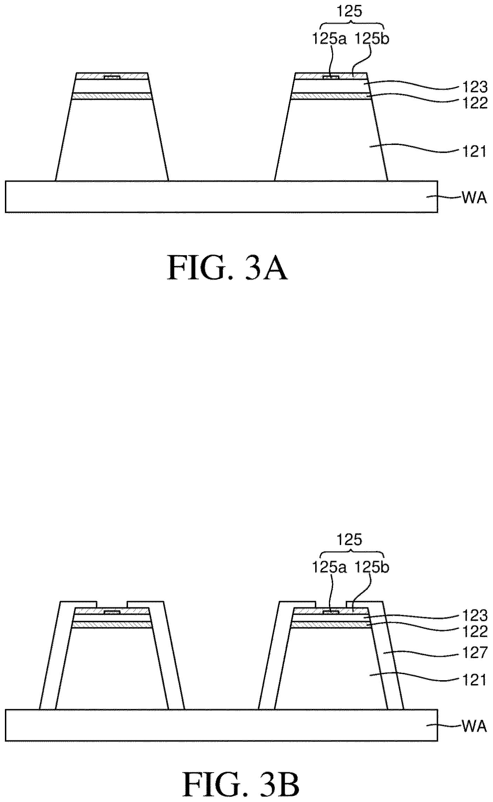

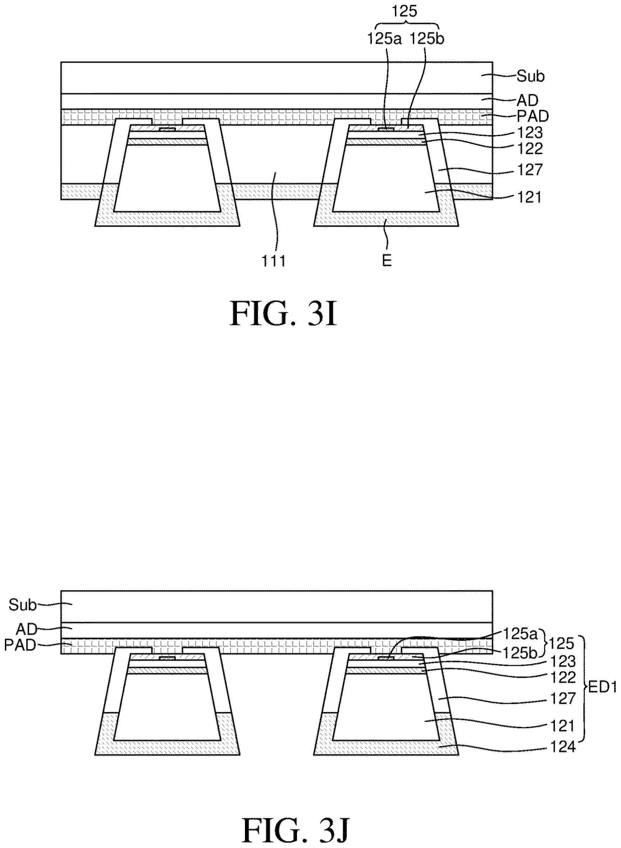

Hereinafter, a method for manufacturing an interposer and a light emitting diode will be described with reference to FIG. 3A through FIG. 3J.

FIG. 3A through FIG. 3J are diagrams illustrating a method for manufacturing an interposer and a light emitting diode according to an example embodiment of the present disclosure.

Referring to FIG. 3A, the first semiconductor layer 121, the emission layer 122, the second semiconductor layer 123, and the second electrode 125 including the 2-1 electrode 125a and the 2-2 electrode 125b may be sequentially provided on a wafer WA. Then, the first semiconductor layer 121, the emission layer 122, the second semiconductor layer 123, and the second electrode 125 may be partially etched. Thus, the first semiconductor layer 121, the emission layer 122, the second semiconductor layer 123, and the second electrode 125 are separated into the light emitting diodes ED1 on the wafer WA. A structure in which the first semiconductor layer 121, the emission layer 122, the second semiconductor layer 123, and the second electrode 125 are laminated serves as an emission structure which is a part of the light emitting diode ED1.

Meanwhile, the emission layer 122 may be formed on various wafers WA depending on the emission wavelength band. For example, when the emission layer 122 is made of a material which emits light in a red wavelength band, the emission layer 122 may be formed on a gallium arsenide (GaAs) wafer WA. Also, when the emission layer 122 is made of materials which emit light in green and blue wavelength bands, the emission layer 122 may be formed on a sapphire wafer WA.

If the wafer WA is a sapphire wafer, an etch stop layer may be further formed between the wafer WA and the first semiconductor layer 121 to suppress damage to the first semiconductor layer 121 during the manufacturing process of the interposer 100 and the light emitting diode ED1.

Referring to FIG. 3B, the passivation layer 127 is provided on a plurality of emission structures. The passivation layer 127 is provided to cover an upper surface of the second electrode 125 and side surface of the first semiconductor layer 121, the second semiconductor layer 123, the emission layer 122, and the second electrode 125. Then, a part of the passivation layer 127 provided on the second electrode 125 to expose the upper surface of the second electrode 125 is removed. In this case, the passivation layer 127 enclosing an edge of the second electrode 125 may not be removed, but may remain.

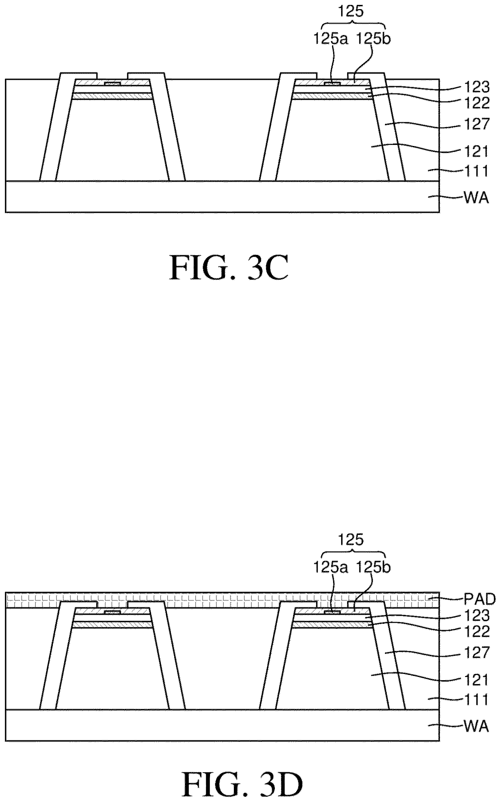

Referring to FIG. 3C, an insulating layer 111 is provided on the wafer WA on which the plurality of emission structures is disposed. The insulating layer 111 may be made of, for example, photo resist or an acryl-based organic material.

The insulating layer 111 encloses a side surface of the passivation layer 127. The insulating layer 111 is provided on the wafer WA except for parts of the second electrodes 125 of the plurality of emission structures. Also, the insulating layer 111 has a height corresponding to the thickness of the plurality of emission structures. Further, the insulating layer 111 is provided only between the plurality of emission structures. A part of an upper portion of the passivation layer 127 and the second electrode 125 are exposed at an upper portion of the insulating layer 111, and a part of a side surface of the second electrode 125 may be exposed.

Referring to FIG. 3D, the common pad PAD is provided on an upper surface of the wafer WA on which the plurality of emission structures is disposed. The common pad PAD may be made of a material which has high electrical conductivity and is also suitable for a sacrificial layer process. For example, the common pad PAD may be made of aluminum (Al) or the like.

The common pad PAD is provided on the insulating layer 111 and upper surfaces of a plurality of second electrodes 125, and is in electrical contact with all the second electrodes 125 of the plurality of emission structures on the wafer WA. Also, the common pad PAD may cover the surface of the insulating layer 111 except for the second electrodes 125 of the plurality of emission structures. Thus, when a slight step is formed between an upper surface of the emission structure and an upper surface of the insulating layer 111, the common pad PAD may have good step coverage, the common pad PAD may be disposed flat.

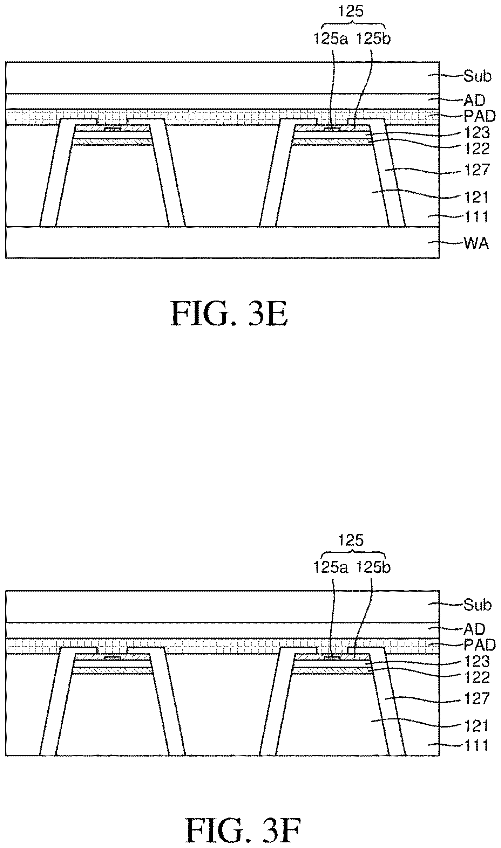

Referring to FIG. 3E, the temporary substrate Sub is bonded onto the common pad PAD. The common pad PAD and the temporary substrate Sub may be bonded to each other using the adhesive layer AD. In this case, the plurality of emission structures and the insulating layer 111 bonded to the common pad PAD are bonded to the temporary substrate Sub together with the common pad PAD. Meanwhile, when a slight step is formed between the upper surfaces of the plurality of emission structures and the upper surface of the insulating layer 111, the adhesive layer AD may be formed to have a flat upper surface. Also, the adhesive layer AD may be bonded to the temporary substrate Sub having a flat surface.

Referring to FIG. 3F, the plurality of emission structures is separated from the wafer WA. In this case, if the wafer WA is a sapphire wafer, the plurality of emission structures may be separated from the wafer WA through a laser process. If the wafer WA is a gallium arsenide wafer, the plurality of emission structures may be separated from the wafer WA through a chemical process. For example, if the wafer WA is a gallium arsenide wafer, the plurality of emission structures may be separated from the wafer WA by using a mixed solution of hydrogen peroxide (H₂O₂) and ammonia (NH₄OH).

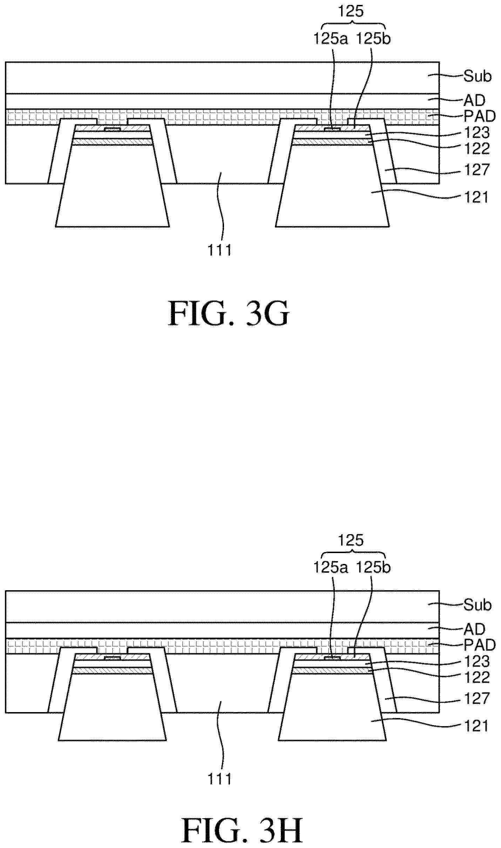

Referring to FIG. 3G, a part of the insulating layer 111 is removed. When the plurality of emission structures is separated from the wafer WA, a lower surface of the first semiconductor layer 121 and one surface of the insulating layer 111 may be exposed. Thus, a part of the insulating layer 111, which is exposed when the wafer WA is removed, is removed. For example, a part of the insulating layer 111 may be removed through a photo-patterning process. In this case, only a part of the insulating layer 111 enclosing the lower side surface of the first semiconductor layer 121 is removed. Thus, a part of the upper portion of the first semiconductor layer 121 may be covered by the insulating layer 111. Since the part of the insulating layer 111 is removed, a part of a lower portion of the first semiconductor layer 121 may protrude compared to the insulating layer 111.

When the part of the insulating layer 111 is removed, a part of the passivation layer 127 may also be removed. Thus, an upper surface of the passivation layer 127 may be disposed on the same plane as the upper surface of the insulating layer 111. Therefore, the passivation layer 127 and the insulating layer 111 may cover the part of the upper portion of the first semiconductor layer 121 and also expose the part of the lower portion of the first semiconductor layer 121.

Referring to FIG. 3H, part of the lower portion of the first semiconductor layer 121 is removed. As the first semiconductor layer 121 is grown on the wafer WA, a residual layer of the first semiconductor layer 121 may be formed on a boundary surface between the wafer WA and the first semiconductor layer 121. For example, a residual layer made of gallium (Ga) may be formed on the lower portion of the first semiconductor layer 121. Therefore, the residual layer may remain on one surface of the first semiconductor layer 121 from which the wafer WA is removed. Then, the residual layer of the first semiconductor layer 121 formed on the lower portion thereof may be removed through an etching process.

Meanwhile, if the wafer WA is a gallium arsenide wafer, an etch stop layer made of indium gallium phosphide is provided between the wafer WA and the first semiconductor layer 121. Then, the etch stop layer disposed between the wafer WA and the first semiconductor layer 121 is removed through an etching process.

Referring to FIG. 31, a conductive layer E is provided under the first semiconductor layers 121 of the plurality of emission structures. The conductive layer E is integrally formed on the wafer WA to cover the plurality of emission structures which protrudes compared to the insulating layer 111. That is, the conductive layer E covers the upper surface of the insulating layer 111 and extends from the upper surface of the insulating layer 111. Thus, the conductive layer E are in contact with the lower side surface of the first semiconductor layer 121 and the lower surface of the first semiconductor layer 121 which protrude compared to the insulating layer 111 and the passivation layer 127.

Referring to FIG. 3J, the insulating layer 111 is removed. In this case, a part of the conductive layer E is removed together with the insulating layer 111. For example, the conductive layer E disposed between the plurality of emission structures is removed, and the conductive layer E is separated corresponding to the plurality of emission structures. Thus, a plurality of first electrodes 124 is provided on the plurality of emission structures. In this case, the plurality of emission structures and the plurality of first electrodes 124 constitute the plurality of light emitting diodes ED1, respectively.

Then, the plurality of first electrodes 124 is connected to the first probe P1 and the common pad PAD is connected to the second probe P2 to inspect optical and electrical properties of the plurality of light emitting diodes ED1.

Thereafter, the common pad PAD is removed to separate, from the temporary substrate Sub, the plurality of emission structures, i.e., the plurality of light emitting diodes ED1, on which the plurality of first electrodes 124 is disposed. For example, the common pad PAD may be removed by using tetramethyl aluminum hydroxide (TMAH).

Meanwhile, before the common pad PAD is removed, only the light emitting diode ED1 determined as being defective may be selectively removed. Thus, the plurality of light emitting diodes ED1 determined as being normal may remain on the temporary substrate Sub, and the common pad PAD may be removed to separate the plurality of light emitting diodes ED1 determined as being normal from the temporary substrate Sub.

Alternatively, before the common pad PAD is removed, the plurality of light emitting diodes ED1 determined as being normal may be separated from the temporary substrate Sub.

Meanwhile, if each of the plurality of light emitting diodes ED 1 is a self-assembly light emitting diode, the light emitting diode ED1 separated from the temporary substrate Sub may be put into a chamber filled with a fluid and a self-assembly process may be performed. Thus, the plurality of light emitting diodes ED1 determined as being normal may be assembled into a self-assembly substrate and then transferred onto the display panel. Alternatively, the plurality of light emitting diodes ED1 determined as being normal may be directly assembled into the display panel on which assembly lines are disposed.

The method for inspecting a light emitting diode may include a photoluminescence (PL) method and an electroluminescence (EL) method. In the case of the PL method, a laser or the like is irradiated to a light emitting diode and light emitted from the light emitting diode is measured. Therefore, the PL method may be performed in a non-contact manner to inspect properties of the light emitting diode. In the case of the EL method, an electrical signal is applied to a light emitting diode in a contact manner to measure properties of the light emitting diode. For example, according to the EL method, a probe of a measuring instrument is brought into contact with each of first and second electrodes of the light emitting diode and a voltage, a current, etc. are applied to the probe to measure optical and electrical properties of light emitted from the light emitting diode.

Meanwhile, in the case of a vertical light emitting diode, a first electrode and a second electrode are disposed with a semiconductor layer interposed therebetween in a vertical direction. Thus, when the vertical light emitting diode is aligned on a temporary substrate, one of the first and second electrodes is covered between the temporary substrate and the semiconductor layer of the light emitting diode. Therefore, in the case of the vertical light emitting diode, it is difficult to bring the probe of the measuring instrument into contact with each of the first and second electrodes. Accordingly, it may be difficult to inspect the light emitting diode by the EL method in a contact manner.

Therefore, in the method for manufacturing the interposer 100 including the light emitting diode ED 1 and the method for inspecting the light emitting diode ED 1 according to an example embodiment of the present disclosure, the EL method can be easily performed by using the interposer 100 including the common pad PAD. For example, the second electrodes 125 of the plurality of light emitting diodes ED 1 are brought into contact with the common pad PAD of the interposer 100, and the first electrodes 124 of the plurality of light emitting diodes ED 1 are exposed to the outside. Thus, the EL method can be easily performed by bringing the probe of the measuring instrument into contact with the common pad PAD and each of the second electrodes 125 of the plurality of light emitting diodes ED1.

Also, in the method for manufacturing the interposer 100 including the light emitting diode ED1 and the method for inspecting the light emitting diode ED1 according to an example embodiment of the present disclosure, the interposer 100 is manufactured together with the light emitting diode ED1. Thus, the manufacturing process can be simplified compared to a case where an interposer and a light emitting diode are manufactured in separate processes. For example, in a process of manufacturing the light emitting diode ED1, before the first electrode 124 is provided, the first semiconductor layer 121, the second semiconductor layer 123, the emission layer 122, and the second electrode 125 provided on the wafer WA are attached onto the temporary substrate Sub on which the common pad PAD is provided. Then, the first electrode 124 is provided on the first semiconductor layer 121 from which the wafer WA is removed. Thus, the plurality of light emitting diodes ED1 can be manufactured simultaneously with the interposer 100 including the plurality of light emitting diodes ED1. Therefore, in the method for manufacturing the interposer 100 including the light emitting diode ED 1 and the method for inspecting the light emitting diode ED1 according to an example embodiment of the present disclosure, the interposer 100 is manufactured simultaneously with the plurality of light emitting diodes ED 1. Thus, the process of manufacturing the interposer 100 and the process of inspecting the plurality of light emitting diodes ED1 can be simplified.

In the method for manufacturing the interposer 100 including the light emitting diode ED1 and the method for inspecting the light emitting diode ED1 according to an example embodiment of the present disclosure, properties of each light emitting diode ED1 can be checked by using the first electrode 124 of the light emitting diode ED1. For example, while the second probe P2 is kept in contact with the common pad PAD, properties of each light emitting diode ED1 can be checked by moving the first probe P1. Thus, inspection can be performed for each light emitting diode ED 1, and the accuracy in inspection can be improved. Therefore, only light emitting diodes ED1 determined as being normal except for light emitting diodes ED1 determined as being defective are transferred onto the display panel. Accordingly, the process yield can be improved and the process cost can be reduced.

In the method for manufacturing the interposer 100 including the light emitting diode ED1 and the method for inspecting the light emitting diode ED1 according to an example embodiment of the present disclosure, the first electrode 124 in each of the plurality of light emitting diodes ED1 may extend from the lower surface of the first semiconductor layer 121 to cover a part of the side surface of the first semiconductor layer 121. Thus, in a process of transferring the plurality of light emitting diodes ED1 onto the display panel or assembling the plurality of light emitting diodes ED1 into the assembly substrate, the plurality of light emitting diodes ED1 can be easily connected to the display panel.

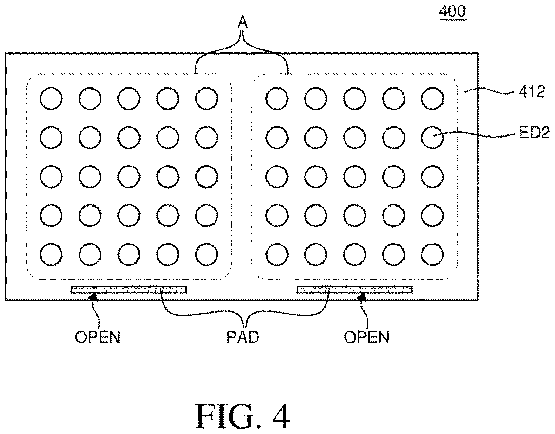

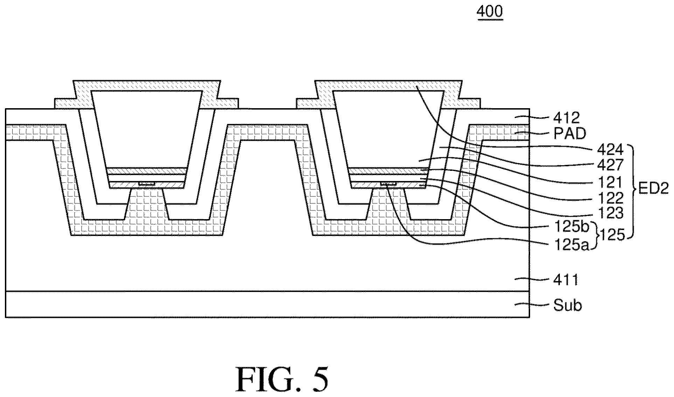

FIG. 4 is an enlarged plan view of an interposer according to another example embodiment of the present disclosure. FIG. 5 is a cross-sectional view of the interposer according to another example embodiment of the present disclosure.

Referring to FIG. 5, the temporary substrate Sub is disposed at the lower portion of the interposer 100. The temporary substrate Sub may be made of an insulating material.

An insulating layer 411 is disposed on the temporary substrate Sub. The insulating layer 411 is disposed between the temporary substrate Sub and the common pad PAD.

The insulating layer 411 may be made of an organic material. For example, the insulating layer 411 may be made of photo acryl (PAC), polyimide (PI), polynorbornene (PNB), and benzocyclobutene (BCB).

The insulating layer 411 may have a thickness corresponding to the height of a plurality of light emitting diodes ED2. Meanwhile, the insulating layer 411 may include a plurality of grooves. For example, a lower surface of the insulating layer 411 may be disposed along a flat upper surface of the temporary substrate Sub. An upper surface of the insulating layer 411 may be recessed toward the lower surface of the insulating layer 411 at the plurality of grooves.

The plurality of light emitting diodes ED2 to be described later may be disposed in the plurality of grooves of the insulating layer 411.

The common pad PAD is disposed on the insulating layer 411.

The common pad PAD is disposed along the upper surface of the insulating layer 411. Thus, the common pad PAD may be disposed to be curved along the shape of the plurality of grooves in an overlap area with the plurality of grooves. For example, in the overlap area with the plurality of grooves, the upper surface of the common pad PAD may be disposed lower than the upper surface of the common pad PAD disposed outside the plurality of grooves.

The common pad PAD may be made of a conductive material suitable for a sacrificial layer process. For example, the common pad PAD may be made of aluminum (Al) or the like, but is not limited thereto.

An additional insulating layer 412 is disposed on the common pad PAD. The additional insulating layer 412 is disposed along the shape of the common pad PAD disposed in the plurality of grooves. Thus, the additional insulating layer 412 may be disposed to be curved along the plurality of grooves.

The additional insulating layer 412 may be made of an insulating material suitable for a sacrificial layer process. For example, the additional insulating layer 412 may be an inorganic insulating layer and may be made of a material such as silicon oxide (SiO₂), but is not limited thereto.

Meanwhile, the additional insulating layer 412 may expose one surface of the common pad PAD disposed in the overlap area with the plurality of grooves. Thus, the common pad PAD exposed by the additional insulating layer 412 may be in contact with the second electrodes 125 of the plurality of light emitting diodes ED2 to be described later.

Meanwhile, an upper surface of the additional insulating layer 412 may be disposed on the same plane as upper surfaces of passivation layers 427 of the plurality of light emitting diodes ED2.

Referring to FIG. 4, the additional insulating layer 412 may include an open area OPEN. The additional insulating layer 412 may cover the upper surface of the temporary substrate Sub except for the open area OPEN and expose the upper surface of the common pad PAD in the open area OPEN.

The open area OPEN may be disposed to bring a probe of an inspection device into contact with the common pad PAD. Meanwhile, the open area OPEN may be disposed for each unit area A. However, the present disclosure is not limited thereto.

The plurality of light emitting diodes ED2 is disposed on the additional insulating layer 412.

The plurality of light emitting diodes ED2 may be disposed in the plurality of grooves, respectively, of the insulating layer 411. Thus, side portions of the plurality of light emitting diodes ED2 may be enclosed by a side surface of the additional insulating layer 412 enclosing the plurality of grooves.

Each of the plurality of light emitting diodes ED2 includes the first semiconductor layer 121, the emission layer 122, the second semiconductor layer 123, a first electrode 424, the second electrode 125, and the passivation layer 427.

The light emitting diode ED2 illustrated in FIG. 5 has substantially the same configuration as the light emitting diode ED1 illustrated in FIG. 1A through FIG. 2B except for, among others, the first electrode 424 and the passivation layer 427. Therefore, repeated description is omitted.

Referring to FIG. 5, the second semiconductor layer 123, the emission layer 122, and the first semiconductor layer 121 of the light emitting diode ED2 are sequentially disposed on the common pad PAD. Also, the first electrode 424 is disposed on the first semiconductor layer 121.

Meanwhile, an upper surface of the first semiconductor layer 121 may be disposed higher than the upper surface of the passivation layer 427, the upper surface of the additional insulating layer 412, and the upper surface of the insulating layer 411. In this case, the first electrode 424 of the light emitting diode ED2 may extend from the upper portion of the first semiconductor layer 121 to an upper portion of the passivation layer 427. In this case, the first electrode 424 may cover a part of the side surface of the first semiconductor layer 121 exposed by the passivation layer 427. The first electrode 424 in each of the plurality of light emitting diodes ED2 may extend from the upper portion of the first semiconductor layer 121 and may also be disposed on the additional insulating layer 412.

Meanwhile, the first electrode 424 in each of the plurality of light emitting diodes ED2 may cover only a part of the upper surface of the additional insulating layer 412 disposed in a region adjacent to the plurality of light emitting diodes ED2. Therefore, the first electrode 424 may expose a part of the upper surface of the additional insulating layer 412 in a region between the plurality of light emitting diodes ED2.

The second electrode 125 disposed under the second semiconductor layer 123 may be in contact with the common pad PAD exposed by the additional insulating layer 412 in the plurality of grooves.

The second electrode 125 may include the 2-1 electrode 125a and the 2-2 electrode 125b.

The 2-1 electrode 125a may contain a ferromagnetic material, and the 2-2 electrode 125b may be made of a transparent conductive material such as indium tin oxide (ITO) or indium zinc oxide (IZO), but is not limited thereto.

Then, the passivation layer 427 enclosing the first semiconductor layer 121, the emission layer 122, the second semiconductor layer 123, and the second electrode 125 is disposed.

Meanwhile, the passivation layer 427 may enclose the entire side portion of the emission layer 122 and the second semiconductor layer 123 and may also expose the upper side surface of the first semiconductor layer 121.

The passivation layer 427 may include a contact hole for exposing the second electrode 125. Thus, the second electrode 125 exposed by the passivation layer 427 may be in contact with the common pad PAD.

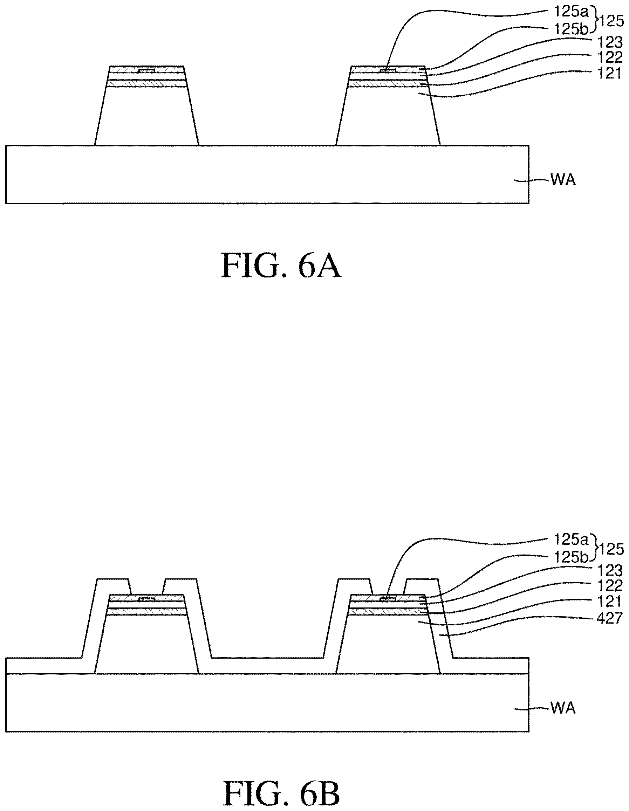

Hereinafter, a method for manufacturing an interposer and a light emitting diode will be described with reference to FIG. 6A through FIG. 6J.

FIG. 6A through FIG. 6J are diagrams illustrating a method for manufacturing an interposer and a light emitting diode according to another example embodiment of the present disclosure.

Referring to FIG. 6A, the first semiconductor layer 121, the emission layer 122, the second semiconductor layer 123, and the second electrode 125 including the 2-1 electrode 125a and the 2-2 electrode 125b may be sequentially provided on the wafer WA. Then, the first semiconductor layer 121, the emission layer 122, the second semiconductor layer 123, and the second electrode 125 may be partially etched to form an emission structure.

Referring to FIG. 6B, the passivation layer 427 is provided on the plurality of emission structures. The passivation layer 427 may cover the upper surface of the second electrode 125 and the side surfaces of the first semiconductor layer 121, the second semiconductor layer 123, the emission layer 122, and the second electrode 125. Then, a part of the passivation layer 427 provided on the second electrode 125 to expose the upper surface of the second electrode 125 is removed.

Meanwhile, the passivation layer 427 may be disposed extending between adjacent emission structures. Thus, the passivation layer 427 may cover an upper surface of the wafer WA exposed between the adjacent emission structures.

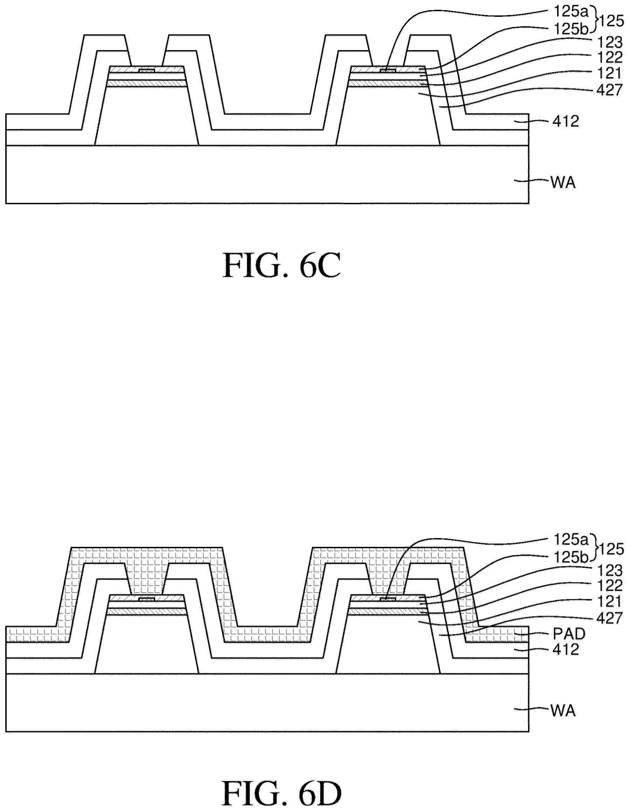

Referring to FIG. 6C, the additional insulating layer 412 is provided on the wafer WA on which the plurality of emission structures is disposed. The additional insulating layer 412 may be made of a material suitable for a sacrificial layer process. For example, the additional insulating layer 412 may be an inorganic insulating layer and may be made of a material such as silicon oxide (SiO₂), but is not limited thereto.

The additional insulating layer 412 is provided on the wafer WA except for parts of the second electrodes 125 of the plurality of emission structures. Also, the additional insulating layer 412 is disposed along the shape of the plurality of emission structures protruding on the wafer WA. Thus, the additional insulating layer 412 may be disposed to be curved along the shape of the plurality of emission structures.

Also, the additional insulating layer 412 may be disposed extending between adjacent emission structures. Thus, the additional insulating layer 412 may cover the upper surface of the passivation layer 427 between the adjacent emission structures.

The additional insulating layer 412 may be provided on the upper surface of the wafer WA. Thus, the additional insulating layer 412 may extend between the plurality of emission structures and may be disposed extending between the plurality of emission structures.

Referring to FIG. 6D, the common pad PAD to be in contact with the second electrode 125 is provided on the wafer WA on which the plurality of emission structures is disposed. The common pad PAD may be made of a material which has high electrical conductivity and is also suitable for a sacrificial layer process. For example, the common pad PAD may be made of aluminum (Al) or the like.

The common pad PAD is provided on the additional insulating layer 412, and is in electrical contact with all the second electrodes 125 of the plurality of emission structures exposed by the additional insulating layer 412. Also, the common pad PAD may cover the upper surface of the additional insulating layer 412 except for the second electrodes 125 of the plurality of emission structures.

Further, the common pad PAD may extend between the plurality of emission structures, and may be disposed to be curved along the shape of the plurality of emission structures disposed on the wafer WA.

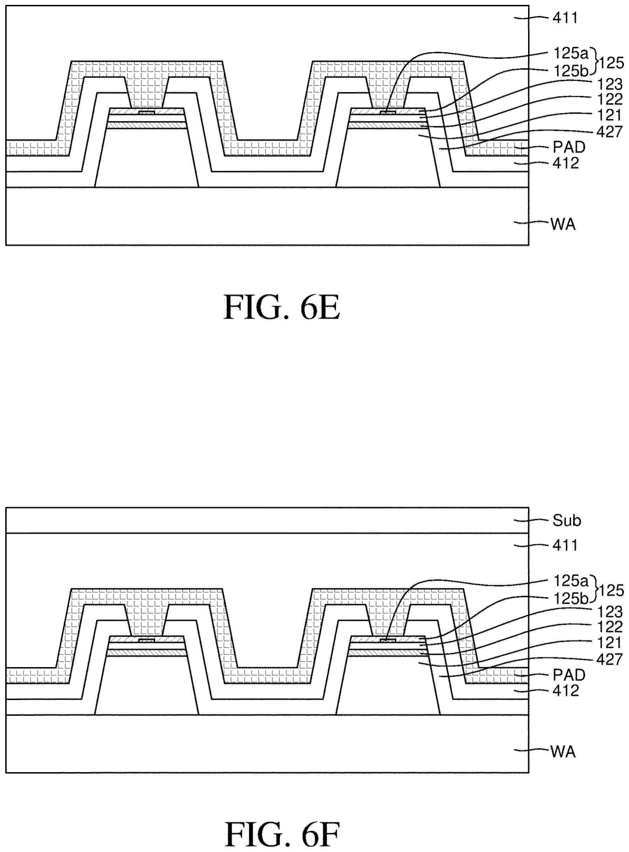

Referring to FIG. 6E, the insulating layer 411 is provided on the common pad PAD. The insulating layer 411 may have a thickness corresponding to the height of the plurality of emission structures. Also, the insulating layer 411 may fill a gap between the plurality of emission structures adjacent to each other and may have a flat upper surface. Thus, the lower surface of the insulating layer 411 may have a step along the protruding surfaces of the plurality of emission structures. The insulating layer 411 may have a flat upper surface. Therefore, the insulating layer 411 may cover a step of the common pad PAD formed by the plurality of emission structures disposed on the wafer WA.

The insulating layer 411 may be made of, for example, photo resist or an acryl-based organic material, but is not limited thereto.

Referring to FIG. 6F, the temporary substrate Sub is attached onto the common pad PAD. The temporary substrate Sub is attached to the flat upper surface of the insulating layer 411.

Although not illustrated in FIG. 6F, an adhesive layer may serve to bond the temporary substrate Sub to the insulating layer 411.

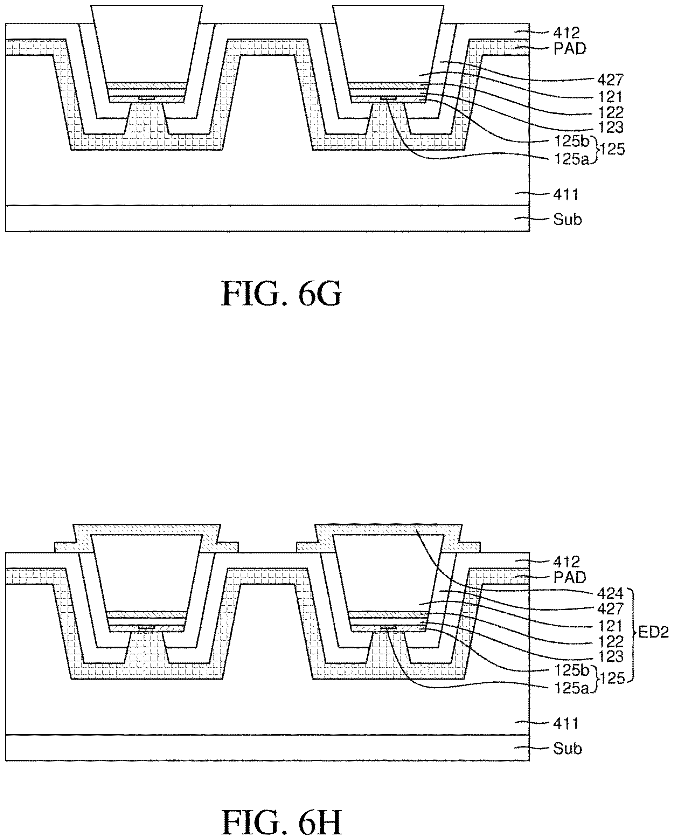

Referring to FIG. 6G, the plurality of emission structures is separated from the wafer WA. In this case, if the wafer WA is a sapphire wafer, the plurality of emission structures may be separated from the wafer WA through a laser process. If the wafer WA is a gallium arsenide wafer, the plurality of emission structures may be separated from the wafer WA through a chemical process. For example, if the wafer WA is a gallium arsenide wafer, the plurality of emission structures may be separated from the wafer WA by using a mixed solution of hydrogen peroxide (H₂O₂) and ammonia (NH₄OH).

In this case, a part of the passivation layer 427 may also be removed. When the wafer WA is separated from the plurality of light emitting diodes ED2, the passivation layer 427 extending between the plurality of emission structures may be exposed. Then, the passivation layer 427 exposed between the plurality of emission structures is removed. Therefore, the passivation layer 427 may be separated between the plurality of emission structures, and the upper surface of the passivation layer 427 may be disposed on the same plane as the upper surface of the additional insulating layer 412.

Since the part of the passivation layer 427 is removed, the lower side surface of the first semiconductor layer 121 covered by the passivation layer 427 may protrude higher than the insulating layer 411 and the additional insulating layer 412.

Referring to FIG. 6H, a plurality of first electrodes 424 is provided on the first semiconductor layers 121 of the plurality of emission structures, respectively. The plurality of first electrodes 424 is spaced apart from each other among the plurality of emission structures. For example, a metal layer may be disposed extending between the plurality of emission structures and each of the plurality of emission structures may be separated from each other. As a result, the plurality of first electrodes 424 may be separated for the respective emission structures.

Thus, the plurality of emission structures and the plurality of first electrodes 424 constitute the plurality of light emitting diodes ED2, respectively.

Meanwhile, the first electrode 424 covers the plurality of emission structures protruding compared to the insulating layer 411 and the additional insulating layer 412. That is, the first electrode 424 may extend from the upper surface of the first semiconductor layer 121 to cover a part of the side surface of the first semiconductor layer 121 and the upper surface of the additional insulating layer 412 disposed around the plurality of light emitting diodes ED2.

Then, the plurality of first electrodes 424 is connected to the first probe P1 and the common pad PAD is connected to the second probe P2 to inspect optical and electrical properties of the plurality of light emitting diodes ED2.

Thereafter, the light emitting diode ED2 determined as being defective and the plurality of light emitting diodes ED2 determined as being normal on the temporary substrate Sub may be selected separated from an interposer 400.

When the inspection of the light emitting diodes ED2 is completed, a process of separating the plurality of light emitting diodes ED2 from the interposer 400 is performed.

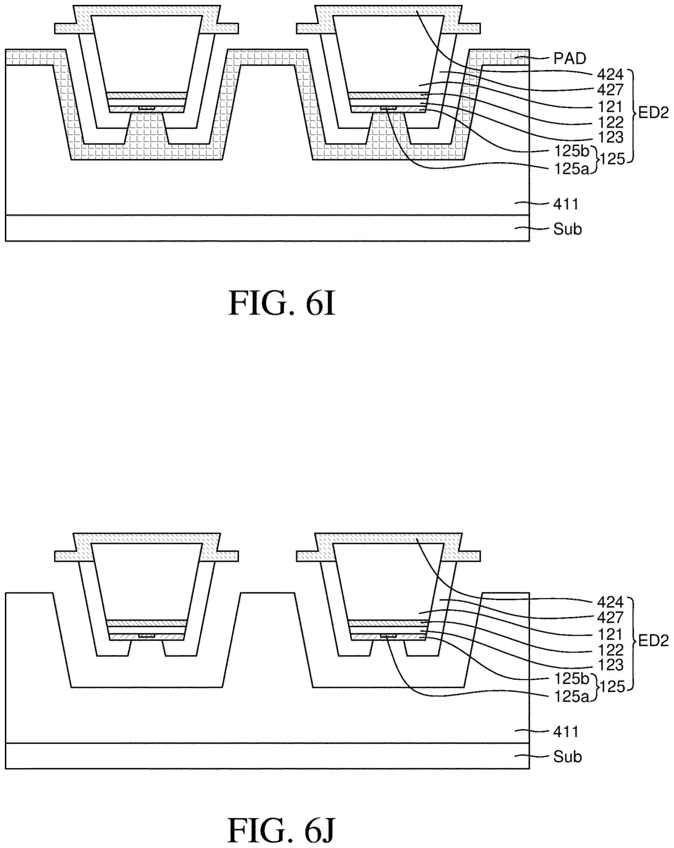

First, referring to FIG. 6I, the additional insulating layer 412 is removed. For example, the additional insulating layer 412 may be removed by performing wet etching with a BOE etching solution. Thus, the common pad PAD disposed under the additional insulating layer 412 may be exposed. In this case, except for a contact area between the common pad PAD and the second electrode 125, a separation space is formed between the light emitting diode ED2 and the common pad PAD to have a width corresponding to the thickness of the additional insulating layer 412.

Then, referring to FIG. 6J, the common pad PAD is removed. The common pad PAD may be removed by using tetramethyl aluminum hydroxide (TMAH). Thus, the insulating layer 411 disposed under the common pad PAD is exposed, and the plurality of light emitting diodes ED2 attached to the common pad PAD may be separated from the temporary substrate Sub.

In the method for manufacturing the interposer 400 including the light emitting diode ED2 and the method for inspecting the light emitting diode ED2 according to another example embodiment of the present disclosure, the second electrodes 125 of the plurality of light emitting diodes ED2 are brought into contact with the common pad PAD. Thus, the EL method can be easily performed by bringing the probe of the measuring instrument into contact with the common pad PAD and each of the second electrodes 125.

In the method for manufacturing the interposer 400 including the light emitting diode ED2 and the method for inspecting the light emitting diode ED2 according to another example embodiment of the present disclosure, the interposer 400 is manufactured together with the light emitting diode ED2. Thus, the manufacturing process can be simplified compared to a case where an interposer and a light emitting diode are manufactured in separate processes.

In the method for manufacturing the interposer 400 including the light emitting diode ED2 and the method for inspecting the light emitting diode ED2 according to another example embodiment of the present disclosure, properties of each light emitting diode ED2 can be checked by bringing the probe of the inspection instrument into contact with the first electrode 424 of each light emitting diode ED2. Accordingly, the process yield can be improved and the process cost can be reduced.

In the method for manufacturing the interposer 400 including the light emitting diode ED2 and the method for inspecting the light emitting diode ED2 according to another example embodiment of the present disclosure, the first electrode 424 in each of the plurality of light emitting diodes ED2 may extend from the lower surface of the first semiconductor layer 121 to cover a part of the side surface of the first semiconductor layer 121. Thus, in a process of transferring the plurality of light emitting diodes ED2 onto the display panel or assembling the plurality of light emitting diodes ED2 into the assembly substrate, the plurality of light emitting diodes ED2 can be easily connected to the display panel.

In the method for manufacturing the interposer 400 including the light emitting diode ED2 and the method for inspecting the light emitting diode ED2 according to another example embodiment of the present disclosure, the light emitting diode ED2 is attached to the common pad PAD by using the additional insulating layer 412 which is an inorganic insulating layer suitable for a sacrificial layer process. Thus, luminous properties of the light emitting diode ED2 may be inspected, and then, a wet etching process is performed to separate the common pad PAD from the light emitting diode ED2. Accordingly, it is possible to omit a photolithography process which is performed when the common pad PAD is attached to the light emitting diode ED2 by using an organic insulating layer. Therefore, it is possible to suppress contamination of the light emitting diode ED2 caused by the photolithography process.

In one or more aspects, luminous properties of a plurality of light emitting diodes ED1, ED2 may correspond to (or include) luminous properties of a plurality of emission structures. In one or more aspects, luminous properties may include optical and electrical properties. In one or more examples, luminous properties may include aspects of brightness, color, luminescence, reflectivity, transparency, opacity and/or scattering. In one or more examples, a probe may include one or more probes. In one or more examples, a wafer may be a substrate that is removable or separable.

Various examples and aspects of the present disclosure are described below. These are provided as examples, and do not limit the scope of the present disclosure.

According to one or more aspects of the present disclosure, there is provided an interposer. The interposer may comprise a temporary substrate, a common pad disposed on the temporary substrate and a plurality of light emitting diodes (LEDs) disposed on the common pad, wherein each of the plurality of light emitting diodes includes a first electrode, a first semiconductor layer, an emission layer, a second semiconductor layer, a second electrode, and a passivation layer, wherein the second electrode, the second semiconductor layer, the emission layer, the first semiconductor layer and the first electrode have a structure formed from sequential lamination, wherein the passivation layer encloses the second semiconductor layer, the emission layer and the first semiconductor layer, wherein the common pad is connected to the second electrode for electrical connection at a lower side of the plurality of light emitting diodes, and wherein the first electrode in each of the plurality of light emitting diodes extends to an upper portion of the passivation layer.

The interposer may further comprise an adhesive layer disposed between the temporary substrate and the common pad.

The interposer may further comprise an insulating layer enclosing the plurality of light emitting diodes in a region between the plurality of light emitting diodes and exposing parts of upper portions of the plurality of light emitting diodes, wherein the insulating layer may be disposed between the temporary substrate and the common pad.

The insulating layer may include a plurality of grooves, and the plurality of light emitting diodes may be disposed in the plurality of grooves.

The common pad may be disposed along a shape of the plurality of grooves.

The interposer may further comprise an additional insulating layer disposed on the common pad, wherein the additional insulating layer may be disposed along a shape of the common pad disposed in the plurality of grooves.

An upper surface of the passivation layer may be disposed on a same plane as an upper surface of the additional insulating layer.

The additional insulating layer may comprise (or be made of) an inorganic material.

The insulating layer may comprise (or be made of) an organic material.

The common pad may comprise (or be made of) aluminum.

According to one or more aspects of the present disclosure, there is provided a method for inspecting a plurality of light emitting diodes disposed on a temporary substrate, wherein each of the plurality of light emitting diodes may comprise a first electrode, a first semiconductor layer, an emission layer, a second semiconductor layer, and a second electrode. The method may comprise providing, on a wafer, a plurality of emission structures, wherein each of the plurality of emission structures includes the first semiconductor layer, the emission layer overlapping the first semiconductor layer, the second semiconductor layer overlapping the emission layer, and the second electrode overlapping the second semiconductor layer, providing a common pad connected to the second electrode on an upper surface of the wafer, attaching the temporary substrate to the common pad, removing the wafer, providing the first electrodes on first surfaces of the plurality of emission structures from which the wafer is removed, and inspecting luminous properties of the plurality of emission structures by electrically connecting probes to the common pad and the plurality of light emitting diodes, and wherein inspecting the luminous properties of the plurality of emission structures includes connecting at least one of the first electrodes to a first probe and connecting the common pad to a second probe.

In providing the common pad, the common pad may be connected to all of the second electrodes of the plurality of emission structures for electrical connection.

The method may further comprise providing an insulating layer enclosing side surfaces of the plurality of emission structures before providing the common pad, wherein the common pad may cover a surface of the insulating layer except for the second electrodes of the plurality of emission structures.

In providing the insulating layer, the insulating layer may be provided except for parts of the second electrodes of the plurality of emission structures and may have a height corresponding to a thickness of the plurality of emission structures.

The method may further comprise removing a part of the insulating layer in order for the plurality of emission structures to protrude compared to the insulating layer after removing the wafer, wherein in providing the first electrodes, the first electrodes may be provided on protruding portions of the plurality of emission structures.

The method may further comprise separating the temporary substrate from the plurality of emission structures on which the first electrodes may be disposed by removing the common pad after inspecting the luminous properties of the plurality of emission structures.

The method may further comprise providing an additional insulating layer enclosing side surfaces of the plurality of emission structures before providing the common pad, wherein the additional insulating layer may be disposed along a shape of the plurality of emission structures protruding on the wafer.

The common pad may be disposed to cover a surface of the additional insulating layer except for the second electrodes of the plurality of emission structures.

The method may further comprise providing an insulating layer enclosing the side surfaces of the plurality of emission structures after providing the common pad, wherein the insulating layer may cover a step of the plurality of emission structures protruding on the wafer, and in attaching the temporary substrate, the temporary substrate may be attached to one surface of the insulating layer.

The method may further comprise removing the additional insulating layer after inspecting the luminous properties of the plurality of emission structures. The method may further comprise removing the common pad after removing the additional insulating layer, wherein in removing the common pad, the temporary substrate may be separated from the plurality of emission structures on which the first electrodes are disposed.

Inspecting the luminous properties of the plurality of emission structures may further include selectively removing, from the temporary substrate, one or more emission structures determined as being defective.

According to one or more aspects of the present disclosure, there is provided an interposer. The interposer may comprise a substrate, a common pad on the substrate, and a plurality of light emitting diodes (LEDs) on the common pad, wherein each of the plurality of light emitting diodes includes a first electrode, an emission layer, a second electrode, and a passivation layer, the emission layer is disposed between the first electrode and the second electrode, the passivation layer encloses the emission layer, the common pad is connected to the second electrode for electrical connection through an opening at a lower portion of the passivation layer, the first electrode extends to an upper portion of the passivation layer, and the passivation layer of each of the plurality of light emitting diodes is separate and isolated from one or more other passivation layers of the plurality of light emitting diodes.

According to one or more aspects of the present disclosure, there is provided a method for manufacturing an interposer comprising a plurality of light emitting diodes, wherein each of the plurality of light emitting diodes may comprise a first electrode, an emission layer, a second electrode and a passivation layer. The method may comprise: providing, on a wafer, a plurality of emission structures, wherein each of the plurality of emission structures includes the second electrode and the emission layer overlapping the second electrode; providing, on the wafer, the passivation layer enclosing the emission layer; providing a common pad, wherein the common pad is connected to the second electrode of each of the plurality of emission structures through an opening in the passivation layer of each respective one of the plurality of emission structures; attaching a substrate to the common pad; removing the wafer; and providing the first electrodes on surfaces of the plurality of emission structures from which the wafer is removed.

Although the example embodiments of the present disclosure have been described in detail with reference to the accompanying drawings, the present disclosure is not limited thereto and may be embodied in many different forms without departing from the technical concept of the present disclosure. Therefore, the example embodiments of the present disclosure are provided for illustrative purposes only but not intended to limit the technical concept of the present disclosure. The scope of the technical concept of the present disclosure is not limited thereto. Therefore, it should be understood that the above-described example embodiments are illustrative in all aspects and do not limit the present disclosure. The protective scope of the present disclosure should be construed based on the following claims.

## Claims

1. An interposer (100, 400), comprising:
a temporary substrate (Sub);
a common pad (PAD) on the temporary substrate (Sub); and
a plurality of light emitting diodes (ED 1, ED2) on the common pad (PAD),
wherein:
each of the plurality of light emitting diodes (ED1, ED2) includes a first electrode (124, 424), a first semiconductor layer (121), an emission layer (122), a second semiconductor layer (123), a second electrode (125), and a passivation layer (127, 427);
the second electrode (125), the second semiconductor layer (123), the emission layer (122), the first semiconductor layer (121) and the first electrode (124) have a structure formed from sequential lamination;
the passivation layer (127, 427) encloses the second semiconductor layer (123), the emission layer (122) and the first semiconductor layer (121);
the common pad (PAD) is connected to the second electrode (125) for electrical connection at a lower side of the plurality of light emitting diodes (ED 1, ED2); and
the first electrode (124, 424) in each of the plurality of light emitting diodes (ED1, ED2) extends to an upper portion of the passivation layer (127, 427).

2. The interposer (400) according to claim 1, further comprising:
an insulating layer (411) enclosing the plurality of light emitting diodes (ED1) in a region between the plurality of light emitting diodes (ED2) and exposing parts of upper portions of the plurality of light emitting diodes (ED2),
wherein the insulating layer (411) is disposed between the temporary substrate (Sub) and the common pad (PAD),
wherein, preferably, the insulating layer (411) comprises an organic material..

3. The interposer (400) according to claim 2, wherein the insulating layer (411) includes a plurality of grooves, and
the plurality of light emitting diodes (ED2) is disposed in the plurality of grooves.

4. The interposer (400) according to claim 3, wherein the common pad (PAD) is disposed along a shape of the plurality of grooves.

5. The interposer (400) according to claim 4, further comprising:
an additional insulating layer (412) on the common pad (PAD),
wherein the additional insulating layer (412) is disposed along a shape of the common pad (PAD) disposed in the plurality of grooves,
wherein, preferably, the additional insulating layer (412) comprises an inorganic material.

6. The interposer (400) according to claim 5, wherein an upper surface of the passivation layer (427) is disposed on a same plane as an upper surface of the additional insulating layer (412).

7. The interposer (400) according to any of claims 1 to 6, wherein the common pad (PAD) comprises aluminum.

8. A method for inspecting a plurality of light emitting diodes (ED1, ED2) disposed on a temporary substrate (Sub), wherein each of the plurality of light emitting diodes (ED1, ED2) comprises a first electrode (124, 424), a first semiconductor layer (121), an emission layer (122), a second semiconductor layer (123), and a second electrode (125), wherein the method comprises:
providing, on a wafer (WA), a plurality of emission structures, wherein each of the plurality of emission structures includes the first semiconductor layer (121), the emission layer (122) overlapping the first semiconductor layer (121), the second semiconductor layer (123) overlapping the emission layer (122), and the second electrode (125) overlapping the second semiconductor layer (123);
providing a common pad (PAD) connected to the second electrode (125) on an upper surface of the wafer (WA);
attaching the temporary substrate (Sub) to the common pad (PAD);
removing the wafer (WA);
providing the first electrodes (124, 424) on first surfaces of the plurality of emission structures from which the wafer (WA) is removed; and
inspecting luminous properties of the plurality of emission structures by electrically connecting probes (P1, P2) to the common pad (PAD) and the plurality of light emitting diodes (ED1, ED2), and
wherein inspecting the luminous properties of the plurality of emission structures includes:
connecting at least one of the first electrodes (124, 424) to a first probe (P1) and connecting the common pad (PAD) to a second probe (P2), and
preferably, selectively removing, from the temporary substrate (Sub), one or more emission structures determined as being defective.

9. The method according to claim 8, wherein in providing the common pad (PAD), the common pad (PAD) is connected to all of the second electrodes (125) of the plurality of emission structures for electrical connection.

10. The method according to claim 9, further comprising:
providing an insulating layer (111) enclosing side surfaces of the plurality of emission structures before providing the common pad (PAD),
wherein the common pad (PAD) covers a surface of the insulating layer (111) except for the second electrodes (125) of the plurality of emission structures.

11. The method according to claim 10, wherein in providing the insulating layer (111), the insulating layer (111) is provided except for parts of the second electrodes (125) of the plurality of emission structures and has a height corresponding to a thickness of the plurality of emission structures.

12. The method according to claim 11, further comprising:
removing a part of the insulating layer (111) in order for the plurality of emission structures to protrude compared to the insulating layer (111) after removing the wafer (WA),
wherein in providing the first electrodes (124), the first electrodes (124) are provided on protruding portions of the plurality of emission structures; and/or
the method further comprising:
separating the temporary substrate (Sub) from the plurality of emission structures on which the first electrodes (124) are disposed by removing the common pad (PAD) after inspecting the luminous properties of the plurality of emission structures.

13. The method according to claim 8 or 9, further comprising:
providing an additional insulating layer (412) enclosing side surfaces of the plurality of emission structures before providing the common pad (PAD),
wherein the additional insulating layer (412) is disposed along a shape of the plurality of emission structures protruding on the wafer (WA).

14. The method according to claim 13, wherein the common pad (PAD) is disposed to cover a surface of the additional insulating layer (412) except for the second electrodes (125) of the plurality of emission structures.

15. The method according to claim 14, further comprising:
providing an insulating layer (411) enclosing the side surfaces of the plurality of emission structures after providing the common pad (PAD),
wherein the insulating layer (411) covers a step of the plurality of emission structures protruding on the wafer (WA), and
in attaching the temporary substrate (Sub), the temporary substrate (Sub) is attached to one surface of the insulating layer (411),
the method, preferably, further comprising:
removing the additional insulating layer (412) after inspecting the luminous properties of the plurality of emission structures; and
removing the common pad (PAD) after removing the additional insulating layer (412),
wherein in removing the common pad (PAD), the temporary substrate (Sub) is separated from the plurality of emission structures on which the first electrodes (124) are disposed.
